# EUROPÄISCHE PATENTANMELDUNG

(11) **EP 2 492 954 A2**
(43) Veröffentlichungstag der Anmeldung: **29.08.2012**
(21) Anmeldenummer: 12157216.8
(22) Anmeldetag: 28.02.2012
(51) Int. Cl.: H01L 21/02, H01L 31/0216

(54) **Verfahren zur Ausbildung einer Oxidschicht auf einem Halbleiterbauelement**

(30) Priorität: 28.02.2011 DE 102011000973
(71) Anmelder: SCHOTT Solar AG, 55122 Mainz (DE)
(72) Erfinder: Breuer, Kaspar, 65451 Kelsterbach (DE); Manole, Mihail, 63796 Kahl am Main (DE)
(74) Vertreter: Stoffregen, Hans-Herbert

(57) **Zusammenfassung**

Die Erfindung bezieht sich auf ein Verfahren zur Ausbildung einer Oxidschicht auf scheibenförmigen Halbleiterbauelementen auf Siliziumbasis durch flächige Gasphasenbehandlung. Um den Durchsatz zur Ausbildung von Oxidschichten auf aus Silizium bestehenden Halbleiterbauelementen zu erhöhen, ohne dass sich Nachteile in Bezug auf die Oxidschicht ergeben, wird vorgeschlagen, dass die Hableiterbauelemente in einer Vielzahl berührend aufeinander liegend gestapelt und der Gasphasenbehandlung ausgesetzt werden, wobei zur Ausbildung der Oxidschicht die im Stapel angeordneten Halbleiterbauelemente einer Gasatmosphäre ausgesetzt werden, die zumindest ein Gas aus der Gruppe O₂, Wasserdampf mit einem Anteil von zumindest 50 % enthält.

## Beschreibung

Die Erfindung bezieht sich auf ein Verfahren zur Ausbildung einer Oxidschicht auf scheibenförmigen Halbleiterbauelementen auf Siliziumbasis durch flächige Gasphasenbehandlung.

Bei der Herstellung von Solarzellen werden üblicherweise in einem oder mehreren Verfahrensschritten Wafer gasbehandelt, um z. B. die Oberflächen zu reinigen, eine Passivierungsschicht oder Maskierungsschicht aufzubringen oder die Oberflächen zu ätzen, um z. B. einen Emitter mit reduzierter Dotierstoffoberflächenkonzentration herzustellen. Hierzu werden die Wafer beabstandet zueinander in Halterungen positioniert und sodann z. B. in einem Durchlauf- oder Batchverfahren in einer geeigneten Gasphasenatmosphäre behandelt. Dabei erfolgt die flächige Behandlung, also die der Oberfläche des bzw. der Wafer.

Aus Preu et al., THE STATUS OF SILICON SOLAR CELL PRODUCTION TECH-NOLOGY DEVELOPMENT AT FRAUNHOFER ISE, IEEE, 2006, S. 1040 bis 1043 ist es bekannt, Kanten von gestapelten Wafern mittels eines Plasmaprozesses zu ätzen. Der DE-A-10 2008 055 515 ist ein Verfahren zum Ausbilden eines Dotierstoffprofils in Wafern zu entnehmen, die gestapelt werden. Hierzu wird in einem ersten Verfahrensschritt ein erstes Dotierstoffprofil bei getrennt voneinander angeordneten Wafern ausgebildet. Hierzu kann auf die Wafer eine Dotierstoffatome enthaltende Oxidfilmschicht aufgebracht werden. Anschließend werden die Wafer im Stapel zur Ausbildung eines endgültigen Dotierstoffprofils einer Wärmebehandlung ausgesetzt. Anschließend können bei vereinzelten Wafern dotierte Oberflächenbereiche durch Ätzen oder Oxidation entfernt werden.

Nach der US-A-2007/0215596 werden Halbleiterbauelemente im Batch-Verfahren und beabstandet zueinander einer Wärmebehandlung unterzogen.

Aus der US-A-3 183 130 ist ein Verfahren zum Ausbilden von Dotierstoffprofilen in Halbleiterbauelementen bekannt. Hierzu werden zunächst die gegenüber liegenden Seiten des Wafers mit unterschiedlichen Dotierstoffquellen versehen und sodann im Stapel angeordnet, um bei der anschließenden Temperaturbehandlung ein den Stapel aufnehmendes Rohr von einem Spülgas zu durchströmen.

Zur Ausbildung eines dotierten Gebietes in einem Wafer können nach der DE-A-199 08 400 zu prozessierende Wafer zur Vermeidung einer gegenseitigen Berührung gestapelt werden. Hierzu werden zuvor die Wafer mit Aluminiumoxidpulver oder durch Dazwischenlegen von Neutralfolien beabstandet.

Zueinander beabstandete Wafer werden nach der US-A-4 950 156 einer Hochtemperaturbehandlung unterzogen.

Um ein Gasphasenwachstum auf Halbleiterwafern durchzuführen, werden nach der US-A-4 745 088 Wafer von einer vertikal ausgerichteten Halterung aufgenommen, wobei gegebenenfalls zwei Wafer Rücken an Rücken bei ansonsten vorliegender Beabstandung zu weiteren Wafern angeordnet werden können.

Der vorliegenden Erfindung liegt die Aufgabe zu Grunde, den Durchsatz zur Ausbildung von Oxidschichten auf aus Silizium bestehenden Halbleiterbauelementen zu erhöhen, ohne dass sich Nachteile in Bezug auf die Oxidschicht ergeben.

Zur Lösung der Aufgabe wird im Wesentlichen vorgeschlagen, dass die Hableiterbauelemente in einer Vielzahl berührend aufeinander liegend gestapelt und der Gasphasenbehandlung ausgesetzt werden, wobei zur Ausbildung der Oxidschicht die im Stapel angeordneten Halbleiterbauelemente einer Gasatmosphäre ausgesetzt werden, die zumindest ein Gas aus der Gruppe O₂, Wasserdampf mit einem Anteil von zumindest 50 % enthält.

Abweichend vom Stand der Technik werden die Halbleiterbauelemente in großer Anzahl unmittelbar aufeinander liegend, also berührend, der Gasphasenbehandlung zur Ausbildung der Oxidschicht ausgesetzt. Ungeachtet der Stapelanordnung hat sich überraschenderweise gezeigt, dass die Oxidschicht weitgehend gleichmäßig ausgebildet wird, ohne dass "Verdünnungen" auftreten. Etwaige auftretende Oxiddickenüberhöhungen sind nicht von Nachteil.

Insbesondere ist vorgesehen, dass die in einer Vielzahl berührend aufeinander liegenden Halbleiterbauelemente über eine Zeit t₁ mit t₁ ≥ 30 min einer Temperatur T mit T ≥ 800 °C ausgesetzt werden, wobei über zumindest eine Zeit t₂ mit t₂ ≥ 15 min die Gasatmosphäre das zumindest eine Gas aus der Gruppe O₂, Wasserdampf mit einem Anteil von 50 % enthält.

Ferner sollten zumindest 20 Halbleiterbauelemente, vorzugsweise zumindest 50 Halbleiterbauelemente berührend aufeinander liegend in einem Stapel der Gasatmosphäre ausgesetzt werden.

Das unmittelbare Aufeinanderliegen, also das Berühren der Halbleiterbauelemente im Stapel schließt ein, dass die Halbleiterbauelemente durch auf deren Oberflächen ausgebildete oder auf die Oberflächen additiv aufgebrachte Erhebungen oder durch die Welligkeit der Wafer, also Halbleiterbauelemente selbst nicht plan aufeinander liegen.

Die Halbleiterbauelemente werden im Stapel derart zueinander ausgerichtet, dass auf die Frontseite eines Halbleiterbauelementes die Rückseite eines nachfolgenden Halbleiterbauelementes zu liegen kommt und sodann auf die Frontseite dieses Halbleiterbauelementes erneut eine Rückseite eines nachfolgenden Halbleiterbauelementes. Mit anderen Worten werden die Halbleiterbauelemente gleichsinnig ausgerichtet berührend aufeinander gelegt, um sodann im Stapel prozessiert zu werden.

Das Ausbilden von Erhebungen kann z. B. durch Laserbehandlung erfolgen. Dabei sind Höhen bis zu 1 mm erreichbar.

Anstelle von einer Laserbehandlung können auch additive Verfahren zum Einsatz gelangen. Beispielhaft sind Spin-On-Prozesse mit vorheriger Maskierung oder anschließender Strukturierung zu nennen. Als additives Verfahren kann auch ein solches zum Einsatz gelangen, bei dem Sprühen oder Drucken zur Anwendung gelangt. Als weiteres additives Verfahren sind z. B. Inkjet, Aerosoljet, Auftropfen, Laser-Transfer-Printing zu nennen.

Nass- oder trockenchemische Ätzverfahren mit geeigneter Maskierung zur Ausbildung von Erhebungen sind gleichfalls als mögliche Maßnahmen zu nennen.

Die zuvor genannten Verfahren bzw. Maßnahmen zur Ausbildung von Erhebungen, die zu einer Beabstandung der im Stapel angeordneten Halbleiterbauelemente dienen, sind rein beispielhaft und somit nicht einschränkend zu verstehen.

Durch das Ausbilden der Erhebungen, also die geringe Beabstandung der im Stapel vorliegenden Halbleiterbauelemente wie Wafer, ergibt sich der Vorteil, dass die Gasphasenbehandlung gegebenenfalls intensiviert werden kann, da zwischen den Oberflächen eine bessere Diffusion in den Spalt zwischen den Halbleiterbauelementen und damit Versorgung der Oberflächen mit Reaktionsedukten ermöglicht wird.

Als Halbleiterbauelemente können solche verwendet werden, die von einem Siliziumblock z. B. durch läppmittelbasierte Drahtsägen oder Diamantsägen abgetrennt werden.

Unabhängig von der Art, wie die scheibenförmigen Halbleiterbauelemente hergestellt werden, können deren Oberflächen glanzgeätzt oder isotexturiert sein, ohne dass unterschiedliche Ergebnisse bei der flächigen Gasphasenbehandlung im Stapel feststellbar sind. Gleiches gilt für alkalisch texturierte Oberflächen, Plasmatextur, Lasertextur, Honeycomb oder andere Texturierungsverfahren.

Bei alkalisch geätzten Oberflächen belaufen sich typischerweise die Pyramidenhöhen zwischen 1 µm und 10 µm.

Insbesondere ist vorgesehen, dass die im Stapel angeordneten Halbleiterbauelemente zumindest aus einem Gas aus der Gruppe Sauerstoff, Wasserdampf, Inertgas gasbehandelt werden. Als Inertgas kommt insbesondere Stickstoff oder Argon in Frage. Auch eine H₂-Beimischung ist möglich.

Zusätzlich kann das Gas zumindest eine gasförmige Zusatzkomponente in Form einer Chlorverbindung, insbesondere eine Zusatzkomponente aus der Gruppe Dichlorethylen, Trichlorethylen, Trichlorethan, Chlorwasserstoff enthalten. Die Beimischung einer anderen gasförmigen Verbindung mit reinigender Wirkung ist gleichfalls möglich.

Es besteht auch die Möglichkeit, die im Stapel angeordneten Halbleiterbauelemente Sequenzen aus aufeinander folgenden Gasphasenbehandlungen zu unterwerfen. So kann z. B. zunächst eine Reinigung mit Dichlorethylen mit Stickstoff als Trägergas, ggfs. unter Beimischung von Sauerstoff erfolgen. Anschließend können eine oder mehrere Oxidationsstufen durchgeführt werden, wobei z. B. in der ersten Stufe eine Oxidation in Sauerstoffatmosphäre, anschließend eine Oxidation in einer Atmosphäre aus Sauerstoff und Wasserdampf und sodann eine Oxidation unter Wasserdampfatmosphäre durchgeführt wird.

Es besteht jedoch auch die Möglichkeit, in einem einzigen Behandlungsschritt die Oxidschicht auszubilden. In der Oxidationsstufe können die im Stapel angeordneten Halbleiterbauelemente einer Sauerstoffatmosphäre, einer Sauerstoff-Wasserdampf-Atmosphäre oder einer Wasserdampfatmosphäre ausgesetzt werden, wobei der Anteil von Sauerstoff bzw. des Sauerstoff-Wasserdampf-Gemisches bzw. des Wasserdampfs im Gas zumindest 50 %, vorzugsweise zumindest 90 %, zumindest zeitweise während der Gasphasenbehandlung beträgt.

Die Verfahrensstufe Oxidation kann zur Ausbildung einer Passivierungs- oder Maskierungsschicht oder als Vorbereitung für ein Emitter-Rückätzen erfolgen, d. h. zur Erzeugung eines Emitters mit reduzierter Dotierstoff-Oberflächenkonzentration. Durch die Oxidation wird die Phosphorkonzentration im oberflächennahen Bereich des Emitters reduziert. Die Oxidschicht wird sodann weggeätzt.

Bei der Verfahrensstufe Oxidation sind die Verfahrensparameter Temperatur, Zeit, Aufheiz- und Abkühlrate, Atmosphärenzusammensetzung wie Anteil O₂, H₂O, N₂ oder sonstige Gase, Stapelhöhe und Halbleiterbauelementdicke, DCE- bzw. TLC-Beimischung zu beachten.

Typische Verfahrensparameter für Temperatur, Zeit, Aufheiz- und Abkühlrate bzw. Atmosphärenzusammensetzung sind Folgende. So können die gestapelten Halbleiterbauelemente bei einer Temperatur zwischen 700 °C und 1100 °C, insbesondere zwischen 800 °C und 1000 °C, bevorzugterweise zwischen 800 °C und 900 °C über eine Zeit zwischen 1 min. und 8 h prozessiert werden, wobei Aufheiz- und Abkühlraten oberhalb von 700 °C typischerweise zwischen 0,1 °C pro min. bis 30 °C pro min., insbesondere zwischen 5 °C/min. und 15 °C/min. liegen. Bevorzugte Zeiten liegen zwischen 1 min. und 240 min., vorzugsweise 10 min. bis 60 min. oder 60 min. bis 240 min. Bei längeren Zeiträumen ist ein Bereich zwischen 4 h und 24 h, insbesondere zwischen 4 h und 8 h zu bevorzugen.

Die Atmosphärenzusammensetzung sollte zumindest zeitweise liegen für O₂ zwischen 80 % und 100 %, vorzugsweise zwischen 95 % und 100 %, für H₂O zwischen 80 % und 100 %, insbesondere zwischen 95 % und 100 %, für Dichlorethylen (DCE) zwischen 0,001 % und 10 %, vorzugsweise zwischen 0,001 % und 1 %, vorteilhaft zwischen 0,01 % und 0,1 %, und für N₂ zwischen 0 % und 100 %, vorzugsweise zwischen 80 % und 99 % bzw. zwischen 90 % und 98 % bzw. 94 % und 96 %.

Insbesondere ist auch eine Gasphasenbehandlung in einem offenen oder halboffenen Inline-System möglich unter Verwendung von reiner Umgebungsluft oder unter Beimischung von N₂, O₂ oder H₂O. Für diesen Fall sind die bevorzugten Beimischungen:
O₂: 50 % bis 100 %, noch bevorzugter 80 % bis 100 %, wobei die absoluten Konzentrationen von O₂ höher liegen können, da auch die Umgebungsluft bereits einen O₂-Anteil aufweist,
H₂O: 50 % bis 100 %, noch bevorzugter 80 % bis 100 %.
N₂: 0 % bis 100%, vorzugsweise 0 % bis 50 %, noch bevorzugter 0 % bis 10%.

Insbesondere bei Verwendung eines Luft/H₂O-Gemisches ist die Beimischung von O₂ möglich, z. B. zwischen 20 % und 60 %, bevorzugter zwischen 30 % und 50 % (jeweils bezogen auf die H₂O-Menge).

Typische Dicken der Halbleiterbauelemente liegen zwischen 5 µm und 300 µm, bevorzugterweise zwischen 40 µm und 200 µm, noch bevorzugter zwischen 100 µm und 200 µm, noch bevorzugter zwischen 120 µm und 180 µm, noch bevorzugter zwischen 150 µm und 180 µm.

Die Stapelhöhe kann zwischen 1,5 mm und 900 mm liegen, je nachdem, welche Dicke die Halbleiterbauelemente aufweisen.

Typische Stapelhöhen für Bauteile einer Dicke zwischen 150 µm und 200 µm liegen zwischen 1,5 mm und 155 mm, wobei 10 bis 500 Bauteile im Stapel prozessiert werden können.

Bauteile einer Dicke zwischen 100 µm und 150 µm sollten in Stapelhöhen zwischen 1 mm bis 100 mm prozessiert werden.

Eine Behandlung von Halbleiterbauelementen einer Dicke zwischen 50 µm und 100 µm kann in Stapelhöhen zwischen 0,5mm und 200 mm erfolgen.

Weisen die Halbleiterbauelemente Dicken zwischen 100 µm bis 300 µm auf, so kommen Stapelhöhen zwischen 50 mm und 900 mm in Frage.

Das bei der Oxidation entstehende Oxid kann ferner als Passivierung oder Bestandteil einer Passivierung oder auch als Maskierungsschicht für Folgeprozesse z. B. POCl3-Diffusion eingesetzt werden.

Wird das Oxid als Passivierung eingesetzt, so sollte die Dicke des Oxids zwischen 1 nm und 100 nm, bevorzugterweise zwischen 3 nm und 30 nm, noch bevorzugter zwischen 5 nm und 15 nm liegen, oder zwischen 100 nm und 700 nm, vorzugsweise zwischen 150 nm und 400 nm, noch bevorzugter zwischen 200 nm und 300 nm. Erfolgt ein Einsatz als Maskierungsschicht für Folgeprozesse, so sollten die Oxide Dicken vorzugsweise zwischen 10 nm und 700 nm, vorzugsweise zwischen 20 nm und 300 nm, noch bevorzugter zwischen 30 nm und 100 nm, noch bevorzugter zwischen 50 nm und 80 nm liegen.

Zum Ausbilden der Oxidschicht bevorzugter Dicken sollte eine Prozessierung zwischen 700 °C und 1100 °C, vorzugsweise zwischen 800 °C und 1000 °C, noch bevorzugter zwischen 800 °C und 900 °C und eine Prozesszeit von 1 min. bis 240 min., vorzugsweise 10 min. bis 60 min. oder 60 min. bis 240 min. Auch längere Prozesszeiten sind möglich, z. B. 4 h bis 24 h, vorzugsweise 4 h bis 8 h.

Eine Rückseitenpassivierung oder Rückseitenmaskierung erfolgt durch das Ausbilden der Oxidschicht.

Die Gasphasenbehandlung kann bei Normaldruck durchgeführt werden. Auch bei niedrigen Drücken ist eine Verbesserung der Diffusion im Spalt zwischen den Halbleiterbauelementen wie Wafern feststellbar, so dass sich der nutzbare Unterdruckbereich zwischen 10^-7 mbar und 1000 mbar, insbesondere zwischen 0,001 mbar und 1000 mbar, noch bevorzugter zwischen 0,01 mbar und 100 mbar, bzw. der nutzbare Überdruckbereich zwischen 1 bis 10 bar, vorzugsweise zwischen 1 bar und 2 bar ergibt.

Die Einstellung des Druckes ist auch davon abhängig, welche Diffusionsgeschwindigkeit zwischen den Halbleiterbauelementen erzielt werden soll, welche Menge von Edukten benötigt werden, welche Oberflächenrauigkeit der Halbleiterbauelemente gegeben ist. Auch eine Temperaturabhängigkeit ist gegeben.

Bei der Gasphasenbehandlung können die Gase in gewünschter Gaskonzentration zwischen 0 % und 100 % nachstehender Art zum Einsatz gelangen:
O₂, N₂, H₂O, Ar, sonstige Inertgase, Dichlorethylen, Trichlorethylen, Trichlorethan, sonstige chlorhaltige Gase, sonstige Gase mit reinigender Wirkung.

Bevorzugte Atmosphärenzusammensetzungen sind:

| | |
|---|---|
| O₂: | 50 % bis 100 % |
| H₂O: | 50 % bis 100 % |
| Dichlorethylen (DCE): | 0,001 % bis 10 %, bevorzugterweise 0,001 % bis 0,1 % |
| Trichlorethylen: | 0,001 % bis 10 %, bevorzugterweise 0,001 % bis 0,1 % |
| Trichlorethan: | 0,001 % bis 10 %, bevorzugterweise 0,001 % bis 0,1 % |
| Sonstige chlorhaltige Gase: | 0,001 % bis 10 %, bevorzugterweise 0,001 % bis 0,1% |
| Sonstige Gase mit reinigender Wirkung wie Halogene und deren gasförmige Verbindungen: | 0,001% bis 10 %, bevorzugterweise 0,001% bis 0,1 % |
| Inertgas wie N₂ oder Ar: | 0 % bis 100 %, bevorzugterweise 80 % bis 99 %, noch vorteilhafter 90 % bis 98 %, noch vorteilhafter 94 % bis 96 %. |

Anzumerken ist in diesem Zusammenhang, dass die Konzentration sich während des Prozesses ändert.

Üblicherweise liegt bei Erreichen der Prozesstemperatur, also der Temperatur, bei der die im Stapel berührend angeordneten Wafer mit den Oxidschichten auszubilden sind, eine fast 100%ige Inertgasatmosphäre vor. Sodann werden die für die Gasbehandlung benötigten Gase eingeleitet, wobei in einem ersten Schritt eine Reinigung der Oberflächen durchgeführt werden kann. Bei der Ausbildung der Oxidschichten beträgt der Anteil des Gases, aufgrund dessen die Oxidschichten entstehen, zumindest 50 %, wobei zeitweise der Anteil 95 % oder mehr beträgt.

Nach Halten der Temperatur über die erforderliche Zeit zur Erzielung einer gewünschten Oxidschichtdicke, bei der die erforderliche die Oxidation bewirkende Gasatmosphäre im Prozessraum herrscht, erfolgt ein erneutes Spülen mit Inertgas wie N₂, um sodann den Stapel der Atmosphäre auszusetzen.

Insbesondere ist vorgesehen, dass nach Erreichen der Prozesstemperatur und der fast 100%igen Inertgasatmosphäre Gase eingeleitet werden wie z. B. 0,075 Liter/min. N₂-Trägergas mit DCE-Anteil und gleichzeitig 6 Liter/min. O₂. Dadurch steigt der DCE-, N₂-und O₂-Anteil stetig an und kann z.B. nach 60 min. folgende Werte annehmen: 90 % O₂, 9 % N₂, 1 % DCE. Bei noch längerer Spülung mit dem genannten O₂/DCE-Gemisch findet eine Annäherung an 99 % O₂ mit N₂-und DCE-Anteilen von jeweils ca. 0,5 % statt. Es ist auch eine Beimischung von zusätzlichem N₂ denkbar, z.B. 12 Liter/min., so dass die Konzentrationen für O₂ und DCE nach 60 min. ca. 1/3 der oben genannten betragen, nämlich 30 % O₂ und 0,3 % DCE. Der N₂-Anteil wäre dann mit ca. 70 % deutlich höher.

Die Aufnahme von DCE durch das N₂-Trägergas ist temperaturabhängig. Die obengenannten Konzentrationen ergeben sich für eine DCE-Temperatur von 10 °C bis 50 °C, vorzugsweise zwischen 15 °C und 35 °C, noch bevorzugter zwischen 18 °C und 22°C. Auch eine niedrigere Temperatur z. B. 10 °C bis 18 °C ist nutzbar (mit dann reduziertem DCE-Anteil im Trägergas) oder eine höhere Temperatur von 22 °C bis 35 °C oder von 35 °C bis 50 °C oder noch höher mit entsprechend höherem DCE-Anteil im Trägergas.

Statt Dichlorethylen kann mit vergleichbaren Konzentrationen auch Trichlorethan, Trichloretyhlen oder Dichlorethan oder Chlorwasserstoff (oder andere chlorhaltige Gase eingesetzt werden).

Mit dem erfindungsgemäßen Verfahren können ohne Weiteres Stapel prozessiert werden, in denen die 50 bis 150 oder mehr unmittelbar aufeinander liegende oder entsprechend der erfindungsgemäßen Lehre beabstandete scheibenförmige Halbleiterbauelemente prozessiert werden.

Dabei ist es unbeachtlich, welche Rauigkeit die im Stapel angeordneten Halbleiterbauelemente aufweisen. Folglich können problemlos gesägte Wafer mit Rauigkeiten zwischen 0,3 bis 0,7 µm, isotexturierte Wafer mit Rauigkeiten zwischen 0,4 und 1,0 µm und glanzgeätzte Wafer mit einer Rauigkeit zwischen 0,1 und 0,5 µm gestapelt werden.

Die Halbleiterbauelemente, die im Stapel prozessiert werden, können alkalisch texturierte Oberflächen mit einer typischen Pyramidenhöhe zwischen 1 µm und 10 µm aufweisen. Auch größere Rauigkeiten bzw. Pyramidenhöhen sind möglich. Diese sind gegebenenfalls für eine Gasphasenbehandlung geeigneter. Losgelöst hiervon besteht selbstverständlich auch die Möglichkeit, Halbleiterbauelemente mit einer geringeren Rauigkeit zu behandeln.

Unabhängig hiervon können Halbleiterbauelemente benutzt werden, die größere Pyramidenhöhen zwischen 10 µm und 20 µm oder kleinere Pyramiden zwischen 0,5 µm und 1µm bzw. eine größere Rauigkeit zwischen 1 µm bis 3 µm bei einer Isotexturierung oder zwischen 0,5 µm und 2 µm bei Glanzätzung oder eine kleinere Rauigkeit zwischen 0,1 µm und 0,3 µm bei Isotexturierung bzw. 0,03 µm bis 0,1 µm bei Glanzätzung aufweisen.

Gleiches gilt in Bezug auf Halbleiterbauelemente, die herstellungsbedingt eine Welligkeit aufweisen. Diese kann z. B. bei Standardwafern nach dem Sägen im Bereich von 25 µm liegen. Bei diamantgeätzen Wafern wird die Welligkeit erheblich reduziert.

Daher werden bevorzugterweise scheibenförmige Halbleiterbauelemente mit einer Welligkeit zwischen 0,2 µm bis 100 µm und vorzugsweise einer Rauigkeit zwischen 0,03 µm bis 2 µm gestapelt.

Allgemein ist anzumerken, dass eine höhere Welligkeit der Halbleiterbauelemente den Prozess begünstigen kann, gleichwenn erwähntermaßen auch geringere Welligkeiten in Frage kommen.

Werte für eine höhere Welligkeit liegen zwischen 30 µm und 100 µm, vorzugsweise zwischen 30 µm und 50 µm. In Bezug auf eine geringere Welligkeit sind Werte zwischen 0,2 µm und 10 µm, insbesondere zwischen 1 µm und 10 µm anzugeben.

Auch Ribbon-Material kommt in Frage. Dieses zeichnet sich durch eine insgesamt ausgeprägte 3D-Fläche mit Dickenschwankungen von typischerweise 10 µm bis 200 µm aus. Andere Verfahren, die eine 3D-Oberflächenstruktur bewirken, kommen gleichfalls in Frage.

Weitere Einzelheiten und Vorteile der Erfindung ergeben sich nicht nur aus den Ansprüchen, den diesen zu entnehmenden Merkmalen - für sich und/oder in Kombination -, sondern auch aus der nachfolgenden Beschreibung von Beispielen:

### Beispiel 1:

Wafermaterial: multikristallin, Dicke: 180 bis 200 µm, 156 mm x 156 mm vollquadratisch, Vorderseite isotexturiert (Rauigkeit 0,3 µm), Rückseite glanzgeätzt (Rauigkeit 0,15 µm)

Bei der verwendeten Anlage handelte es sich um eine Rohroxidationsanlage mit einer Heiz-und Abkühlrate von 10 °C/min. Die Gasphase war zunächst Luft (bedingt durch das Einfahren der Wafer bei geöffneter Ofentür) und wurde sodann (nach Schließen der Ofentür) mittels Stickstoffeinlass verdrängt. Anschließend wurde das Oxidationsrohr auf Prozesstemperatur erhitzt und das Prozessrohr mit reinem Wasserdampf geflutet, so dass der Stickstoff allmählich verdrängt wurde. Nach 60 min. wurde dann umgekehrt der Wasserdampf mit Stickstoff verdrängt. Nach dem Abkühlen des Prozessrohres auf 800 °C und dem Ausfahren der Wafer wurden die Wafer optisch begutachtet und die Oxiddicke mittels Spektralellipsometrie gemessen und mit anderen Wafern verglichen, welche ebenfalls in demselben Prozess mitoxidiert wurden.

Es wurden 4 Oxidationsprozesse untersucht (2 Variationen: trockenes Oxid vs. feuchtes Oxid und 800 °C vs. 850 °C). Alle Prozesse dauerten 60 min. Der Anteil von O₂ bzw. H₂O in der Prozessraumatmosphäre betrug zumindest 50 % über eine Zeit t₂ mit t₂ in etwa 30 min bei der Prozesstemperatur zwischen 800° C und 900° C, bei der sich die Oxidschichten aus den Oberflächen der Wafer ausbilden. Es wurden in jedem Prozess ein Stapel mit 12 Wafern und 2 frei stehende Wafern oxidiert. Die gestapelten Wafer wurden quer auf die unteren Streben eines Quarzbootes gelegt. Es zeigten sich nur geringe bzw. keine Unterschiede der Oxiddicke in Abhängigkeit
- der Eigenschaft "im Stapel" oder "freistehend" oxdidiert
- der Position im Stapel (oben vs. unten)
- der in Kontakt stehenden Oberfläche des Nachbarwafers im Stapel (isotexturiert vs. glanzgeätzt)

Das Ergebnis war, dass die Oxiddickenunterschiede zwischen freien und in Kontakt stehenden Oberflächen vernachlässigbar waren. Im Mittel lag die Oxidschichtdicke bei einer O₂ Konzentration von zumindest 50 % über die Zeit t₂ bei der Prozesstemperatur von 800° C bei in etwa 13 nm und bei einer Prozesstemperatur von 850° C bei in etwa 18 nm. Enthält die Prozessraumatmosphäre zumindest 50 % Wasserdampt über die Zeit t₂ bei einer Temperatur von 800° C, konnte eine mittlere Oxidschichtdicke von 50 nm und bei einer Temperatur von 850° C eine Oxidschichtdicke von 104 nm festgestellt werden.

Es gab bei einigen Wafern im Stapel eine lokale Oxiddickenüberhöhung (Durchmesser typisch 5 bis 10 mm), welche vermutlich auf lokale Verunreinigung zurückzuführen ist. Die beobachteten lokalen Inhomogenitäten waren immer dicker als die flächige Oxiddicke. Die Lokale Oxiddickenüberhöhung betrug typisch 10 % bis 50 %, in Einzelfällen jedoch bis zum Dreifachen der flächigen Oxiddicke des Wafers. Die Lokale Oxiddickenüberhöhung war immer auf beiden in Kontakt zueinanderstehenden Oberflächen zu finden und jeweils ähnlich stark ausgeprägt. Üblicherweise war der Mittelpunkt der lokalen Oxiddickenüberhöhung am stärksten oxidiert, erkennbar an den mit dem bloßen Auge erkennbaren Newton-Ringen.

### Beispiel 2:

Versuch, bei welchem die Stapeloxidation zur Herstellung einer Passivierung von PERC-Solarzellen genutzt wurde. Durchführung wie Beispiel 1, jedoch wurden dickere Stapel bestehend aus 54 Wafern eingesetzt. Es wurden Wafer beidseitig im Stapel oxidiert (18 Variationen: 3 Temperaturen, 3 Oxidationszeiten, trockene vs. feuchte Oxidation). Dabei wurden jeweils 4 Prozesswafer mittig in einen Stapel aus 50 Dummy-Wafern platziert (25 Dummys + 4 Prozesswafer + 25 Dummys). Es wurden die Temperaturen 800 °C, 850 °C und 900 °C verglichen. Außerdem wurden Prozesszeiten von 10 min., 30 min. und 60 min. verglichen. Dabei wurden Oxiddicken von ca. 5 nm bis ca. 300 nm erzielt. Die Oxide wurden auf der Vorderseite abgeätzt und die auf der Rückseite verbliebenen Oxide wurden als Bestandteil einer PERC-Struktur zur Zellherstellung genutzt. Dabei diente das verbleibende Oxid auf der Waferrückseite als Maskierungsschicht für die anschließende Phosphordiffusion (Emitterprofilausbildung) und gleichzeitig als Rückseitenpassivierung. Für die weitere Prozessierung der Wafer zu fertigen PERC-Zellen wurden Standard-Prozesse aus der industriellen Solarzellenfertigung verwendet. Es zeigten sich keine nennenswerten Unterschiede im Wirkungsgrad zwischen stapeloxidierten und stehend oxidierten Wafern (Unterschied kleiner 0,1 % abs.). Die maximal erreichten Wirkungsgrade bei stapeloxidierten Wafern lagen in diesem Experiment bei 17.1 %.

Der einzigen Figur ist rein prinzipiell zu entnehmen, wie sich die Gasatmosphäre typischerweise im Verlauf des Prozesses verändert, in dem berührend aufeinander liegend ein Stapel von Wafern zur Ausbildung von Oxidschichten auf beiden Seiten prozessiert werden. Gasphasenbehandelt werden dabei aus Silizium bestehende Wafer, die zur Herstellung von Solarzellen benutzt werden. In dem Stapel sind zumindest 50 Wafer angeordnet.

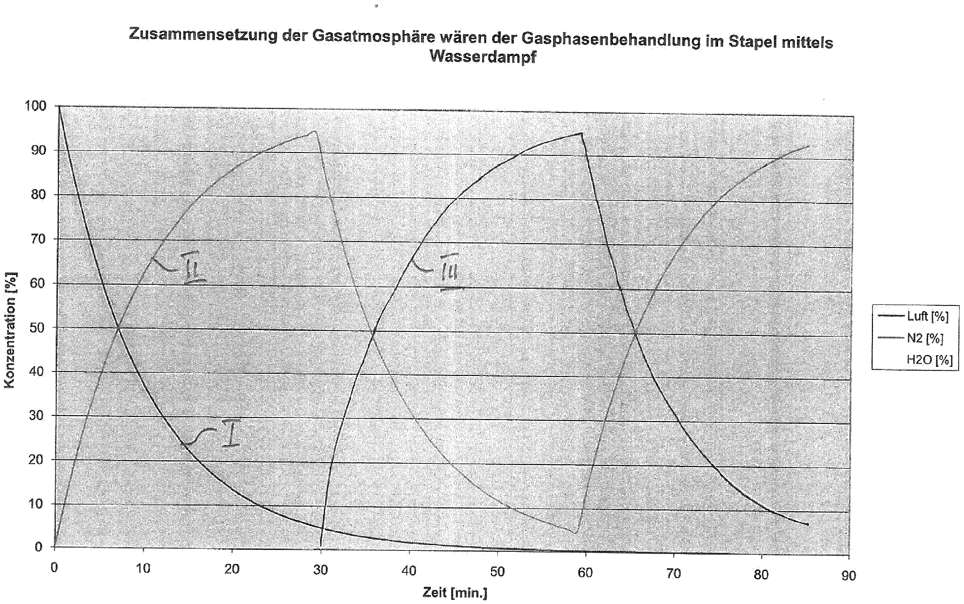

Wie der Figur zu entnehmen ist, befindet sich der Stapel zu Beginn des Gasbehandlungsprozesses der Stapel in Luftatmosphäre. Der Anteil an Luft wird durch die Kurve I verdeutlicht. Sodann wird der Prozessraum mit Inertgas wie N₂ gespült (Kurve II). Bei Erreichen der Prozesstemperatur, also der Temperatur, bei der auf den Schichten die gewünschten Oxidschichten ausgebildet werden sollen, wird der Prozessraum mit dem oxidierenden Prozessgas beaufschlagt. Der Anteil des Inertgases nimmt entsprechend ab und der Anteil des oxidierenden Gases zu (Kurve III). Nachdem über die gewünschte Zeit die Oxidbildung durchgeführt worden ist, wird der Prozessraum erneut mit dem Inertgas gespült, so dass infolgedessen der Anteil des Prozessgases, das im vorliegenden Fall Wasserdampf enthält bzw. aus Wasserdampf besteht, abnimmt. Nachdem der Prozessraum erneut im Wesentlichen mit dem Inertgas gefüllt ist, wird der Stapel an die Atmosphäre übergeben. Dies ist in der Fig. 1 nicht dargestellt.

## Patentansprüche

1. Verfahren zur Ausbildung einer Oxidschicht auf scheibenförmigen Halbleiterbauelementen auf Siliziumbasis durch flächige Gasphasenbehandlung, **dadurch gekennzeichnet,**
**dass** die Halbleiterbauelemente in einer Vielzahl berührend aufeinander liegend gestapelt werden und sodann die Gasphasenbehandlung durchgeführt wird, wobei zur Ausbildung der Oxidschicht die im Stapel angeordneten Halbleiterbauelemente einer Gasatmosphäre ausgesetzt werden, die zumindest ein Gas aus der Gruppe O₂, Wasserdampf mit einem Anteil von zumindest 50 % enthält.

2. Verfahren nach Anspruch 1,
**dadurch gekennzeichnet,**
**dass** die in einer Vielzahl berührend aufeinander liegenden Halbleiterbauelemente über eine Zeit t₁ mit t₁ ≥ 30 min einer Temperatur T mit T ≥ 800 °C ausgesetzt werden, wobei über zumindest eine Zeit t₂ mit t₂ ≥ 15 min die Gasatmosphäre das zumindest eine Gas aus der Gruppe O₂, Wasserdampf mit einem Anteil von 50 % enthält.

3. Verfahren nach Anspruch 1 oder 2,
**dadurch gekennzeichnet,**
**dass** zumindest 20 Halbleiterbauelemente, vorzugsweise zumindest 50 Halbleiterbauelemente berührend aufeinander liegend in einem Stapel der Gasatmosphäre ausgesetzt werden.

4. Verfahren nach zumindest Anspruch 1,
**dadurch gekennzeichnet,**
**dass** auf den Halbleiterbauelementen oberflächenseitig Erhebungen ausgebildet werden.

5. Verfahren nach zumindest Anspruch 4,
**dadurch gekennzeichnet,**
**dass** die über die Oberflächen der Halbleiterbauelemente hervorstehenden Erhebungen durch Laserbehandlung oder durch additive Verfahren ausgebildet werden.

6. Verfahren nach zumindest Anspruch 1,
**dadurch gekennzeichnet,**
**dass** die Oberflächen der Halbleiterbauelemente glanzgeätzt oder isotexturiert werden.

7. Verfahren nach zumindest einem der vorhergehenden Ansprüche,
**dadurch gekennzeichnet,**
**dass** dem Gas zumindest eine gasförmige Chlorverbindung als Zusatzkomponente, insbesondere zumindest eine Zusatzkomponente aus der Gruppe Dichlorethylen, Trichlorethylen, Trichlorethan, Dichlorethan, Chlorwasserstoff zugegeben wird.

8. Verfahren nach zumindest einem der vorhergehenden Ansprüche,
**dadurch gekennzeichnet,**
**dass** die im Stapel angeordneten scheibenförmigen Halbleiterbauelemente Sequenzen aus aufeinander folgenden Gasphasenbehandlungen unterzogen werden, insbesondere zunächst mittels in einem Stickstoffträgergas mit ggfs. Sauerstoffbeimischung enthaltendem Dichlorethylen gereinigt, sodann zur Bildung einer Oxidschicht mit Sauerstoff, zur Bildung einer weiteren Oxidschicht mit einem Gemisch aus Sauerstoff und Wasserdampf und anschließend zur Bildung einer weiteren Oxidschicht mit Wasserdampf behandelt werden.

9. Verfahren nach zumindest einem der vorhergehenden Ansprüche,
**dadurch gekennzeichnet,**
**dass** die durch die Gasbehandlung auf frontseitiger Fläche der zur Herstellung von Solarzellen benutzten Halbleiterbauelemente ausgebildete Oxidschicht nach der Gasphasenbehandlung zumindest bereichsweise entfernt wie weggeätzt wird.

10. Verfahren nach zumindest Anspruch 2,
**dadurch gekennzeichnet,**
**dass** die Gasphasenbehandlung zur Ausbildung der Oxidschicht bei der Temperatur T mit 800°C ≤ T ≤ 900°C über die Zeit t₁ mit 30 min ≤ t₁ ≤ 240 min durchgeführt wird.

11. Verfahren nach zumindest Anspruch 10,
**dadurch gekennzeichnet,**
**dass** die in einer Vielzahl berührend aufeinander liegenden Halbleiterbauelemente der Gasatmosphäre mit dem zumindest einen Gas aus der Gruppe O₂, Wasserdampf mit einem Anteil von zumindest 50 % über die Zeit t₂ mit ⅓ t₁ ≤ t₂ ≤ 2/3 t₁, insbesondere t₂ in etwa ½ t₁ ausgesetzt werden.

12. Verfahren nach zumindest Anspruch 1,
**dadurch gekennzeichnet,**
**dass** die Gasphasenbehandlung bei Normaldruck durchgeführt wird.

13. Verfahren nach zumindest einem der vorhergehenden Ansprüche,
**dadurch gekennzeichnet,**
**dass** die Halbleiterbauelemente gleichsinnig gestapelt werden, wobei bei der Gasphasenbehandlung Längsachse des Stapels vorzugsweise vertikal ausgerichtet ist.
